# EUROPÄISCHE PATENTANMELDUNG

(11) **EP 1 432 047 A2**
(43) Veröffentlichungstag der Anmeldung: **23.06.2004**
(21) Anmeldenummer: 03014504.9
(22) Anmeldetag: 03.07.2003
(51) Int. Cl.: H01L 41/053, H01L 41/06

(54) **Aktor**

(30) Priorität: 19.12.2002 DE 10259731
(71) Anmelder: ROBERT BOSCH GMBH, 70442 Stuttgart (DE)
(72) Erfinder: Liskow, Uwe, 71679 Asperg (DE)

(57) **Zusammenfassung**

Ein Aktor (1), insbesondere zur Betätigung von Brennstoffeinspritzventilen für Brennstoffeinspritzanlagen von Brennkraftmaschinen, umfaßt ein piezoelektrisches oder magnetostriktives Element (2), wobei das piezoelektrische oder magnetostriktive Element (2) in einem elastischen Gehäuse (6) gekapselt ist. Das piezoelektrische oder magnetostriktive Element (2) ist mittels zumindest einem Zwischenstück (8) in dem elastischen Gehäuse (6) verspannt.

## Beschreibung

### Stand der Technik

Die Erfindung geht aus von einem Aktor nach der Gattung des Hauptanspruchs.

Üblicherweise werden piezoelektrische Aktoren zur Betätigung von Brennstoffeinspritzventilen für Brennstoffeinspritzanlagen von Brennkraftmaschinen zur Vermeidung von Zug- und Scherkräften durch eine Feder vorgespannt. Gewöhnlich wird zur Erzeugung einer Vorspannung die auch bei geschlossenem Brennstoffeinspritzventil vorhandene Restspannung der Rückstellfeder des Brennstoffeinspritzventils genutzt.

Beispielsweise ist aus der DE 199 51 012 A1 ein Aktor, insbesondere zur Betätigung von Brennstoffeinspritzventilen für Brennstoffeinspritzanlagen von Brennkraftmaschinen, bekannt, welcher mehrere gestapelt angeordnete Schichten aus einem piezoelektrischen oder magnetostriktiven Material aufweist. Der Aktor wird durch einen in einer zentralen Ausnehmung angeordneten Zuganker mittels gegenläufiger Gewinde vorgespannt. Die Fixierung und Kraftübertragung erfolgt über eine Deckplatte und eine Bodenplatte.

Nachteilig an dieser Bauform ist dabei insbesondere die Notwendigkeit, den Stapelaktor hohl zu gestalten, um den Zuganker in der Ausnehmung unterbringen zu können. Dadurch wird der Aktor noch beschädigungsanfälliger bei Vormontage und Montage.

Weiterhin ist aus der WO 99/08330 ein piezoelektrischer Aktor bekannt, der in eine Federhülse eingeschoben und vorgespannt mit zwei Enden der Federhülse kraft- und/oder formschlüssig verbunden wird. Dadurch wird eine Baueinheit hergestellt, bei der die Vorspannkraft des piezoelektrischen Aktors dauerhaft festgelegt ist.

Nachteilig an diesem Aktor ist insbesondere, daß die Vorspannung des Aktors allein durch die Elastizität der Federhülse vorgegeben ist. Ein progressives Verhalten zur Kompensation von kurzen Ansteuerzeiten kann damit nicht erreicht werden.

### Vorteile der Erfindung

Der erfindungsgemäße Aktor mit den Merkmalen des Hauptanspruchs hat demgegenüber den Vorteil, daß der Aktor sowohl in einem elastischen Gehäuse angeordnet als auch durch zumindest ein Zwischenstück gegenüber dem Gehäuse verspannt ist.

Durch die in den Unteransprüchen aufgeführten Maßnahmen sind vorteilhafte Weiterbildungen und Verbesserungen des im Hauptanspruch gegebenen Aktors möglich.

Vorteilhafterweise können je nach Anforderungen an die Federkräfte ein oder zwei Zwischenstücke vorgesehen sein.

Weiterhin ist von Vorteil, daß die Zwischenstücke in beliebiger Art zwischen den Aktor deckelnden Deck- und Bodenplatten sowie das Gehäuse deckelnden Deckeln eingelegt sein können.

Eine schalenartige Form sowie Auflagekanten oder -flächen sorgen dabei in vorteilhafter Weise für eine gleichmäßige Krafteinleitung.

Zudem ist vorteilhaft, daß die Zwischenelemente auch kugelförmig ausgebildet sein können, was eine einfache Herstellung und eine sichere Verspannung ermöglicht.

### Zeichnung

Ausführungsbeispiele der Erfindung sind in der Zeichnung vereinfacht dargestellt und in der nachfolgenden Beschreibung näher erläutert. Es zeigen:
- Fig. 1: einen axialen Schnitt durch ein erstes Ausführungsbeispiel eines erfindungsgemäßen Aktors;
- Fig. 2: einen axialen Schnitt durch ein zweites Ausführungsbeispiel eines erfindungsgemäßen Aktors; und
- Fig. 3: einen axialen Schnitt durch ein drittes Ausführungsbeispiel eines erfindungsgemäßen Aktors.

### Beschreibung der Ausführungsbeispiele

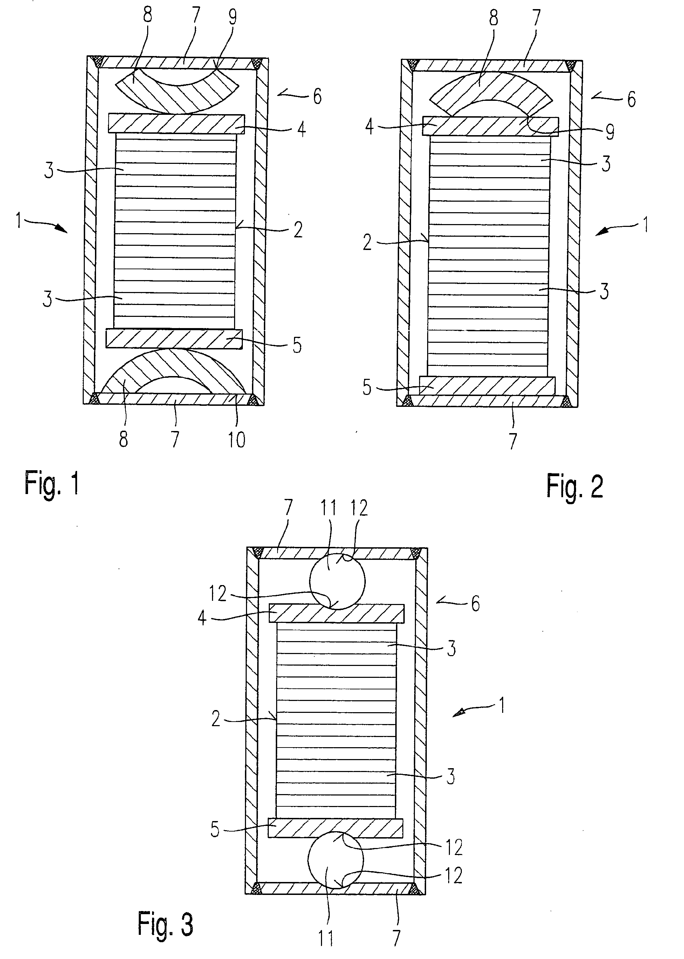

Die Fig. 1 bis 3 zeigen in einer axialen Schnittdarstellung Ausführungsbeispiele für erfindungsgemäß ausgestaltete piezoelektrische oder magnetostriktive Aktoren 1. Der Aktor 1 dient z. B. zur Betätigung eines Brennstoffeinspritzventils, insbesondere zur direkten Einspritzung von Brennstoff in den Brennraum einer gemischverdichtenden, selbst- oder fremdgezündeten Brennkraftmaschine.

Der Aktor 1 besteht aus einem piezoelektrischen oder magnetostriktiven Element 2. Dieses kann sowohl monolithisch ausgeführt sein als auch bevorzugt, wie in den Fig. 1 bis 3 dargestellt, aus scheibenförmigen piezoelektrischen oder magnetostriktiven Schichten 3 bestehen. Die Schichten 3 können untereinander verklebt sein. Der Aktor 1 weist eine Deckplatte 4 und eine Bodenplatte 5 auf, die den Aktor 1 endseitig abschließen, mit den Schichten 3 z. B. verklebt sind und der Kraftübertragung auf die Schichten 3 dienen.

Im folgenden wird zur Vereinfachung ausschließlich auf einen piezoelektrischen Aktor 1 Bezug genommen. Die erfindungsgemäßen Maßnahmen sind jedoch gleichermaßen auch für magnetostriktive Aktoren 1 anwendbar.

Der Aktor 1 ist zur Verwendung in einem nicht weiter dargestellten Brennstoffeinspritzventil von einem Gehäuse 6 umgeben, welches beispielsweise rohrförmig ausgebildet und endseitig mit Deckeln 7 durch Löten oder Schweißen dicht verschlossen ist. Das Gehäuse 6 ist dabei elastisch ausgebildet, um eine durch das Anlegen einer elektrischen Spannung hervorgerufene Verlängerung des piezoelektrischen Elements 2 auf ein nicht näher dargestelltes Betätigungselement, z. B. eine Ventilnadel, übertragen zu können.

Erfindungsgemäß weisen die Aktoren 1 verschiedene Ausführungsformen von Zwischenstücken 8 auf, welche zwischen den Deckeln 7 des Gehäuses 6 und der Bodenplatte 5 bzw. der Deckplatte 4 des Aktors 1 angeordnet sind. Die Zwischenstücke 8 wirken dabei wie zusätzliche Zwischenfedern, welche einerseits einen längeren Federweg und damit eine leichtere Einstellung durch eine höhere Wegauflösung bei der Vorspannung des Aktors 1 ermöglichen. Andererseits wird dadurch ein definierter Krafteinleitungspunkt auf den Aktor 1 erreicht, wodurch sichergestellt werden kann, daß der Aktor 1 nicht exzentrisch verspannt wird. Die Schichten 3 des Aktors 1 werden dadurch nur in axialer Richtung ohne radiale Komponente und somit scherkraftfrei belastet.

Die gemeinsame Federkennlinie des den Aktor 1 vorspannenden Gehäuses 6 und der Zwischenstücke 8 kann durch die gezielte Auswahl einer oder mehrerer Zwischenstücke 8 an die jeweiligen Erfordernisse angepaßt werden. Beispielsweise ist es möglich, das Gehäuse 6 steif auszuführen und die Vorspannung allein durch die Zwischenstücke 8 zu regulieren. Andererseits kann das zumindest eine Zwischenstück 8 auch beispielsweise in Form einer sehr harten Tellerfeder ausgebildet sein, so daß die Federkennlinie fast ausschließlich die Federkraft des Gehäuses 6 darstellt.

Um sicherzustellen, daß der Aktor 1 auch bei extrem kurzer Ansteuerung die Mindestvorspannkraft nicht unterschreitet, kann eine progressive Feder verwendet werden.

Fig. 1 zeigt in einer stark schematisierten Schnittdarstellung ein erstes Ausführungsbeispiel eines erfindungsgemäß ausgestalteten Aktors 1. Übereinstimmende Bauteile sind in allen Fig. mit übereinstimmenden Bezugszeichen versehen.

Das piezoelektrische Element 2 ist, wie bereits weiter oben erläutert, aus piezoelektrischen Schichten 3 aufgebaut und durch eine Deckplatte 4 und eine Bodenplatte 5 gedeckelt. Zwischen den Deckeln 7 des elastischen Gehäuses 6 und der Deckplatte 4 bzw. der Bodenplatte 5 ist jeweils ein Zwischenstück 8 angeordnet, welches wie eine Tellerfeder wirkt, die federnde Elastizität des Gehäuses 6 je nach Federkonstante verstärkt und somit die Gesamtfederkraft des Gesamtbauteils beeinflußt.

Die Zwischenstücke 8 sind dabei schalenförmig ausgebildet und liegen entweder mit einer Auflagekante 9 oder einer Auflagefläche 10 an den Deckeln 7 des Gehäuses 6 an. Insbesondere letzteres ist vorteilhaft, da die Auflagefläche 10 eine gleichmäßigere Kraftverteilung auf den Deckel 7 erlaubt.

Durch die kalottenförmige Ausbildung der Zwischenstücke 8 kann sichergestellt werden, daß die Krafteinleitung auf das piezoelektrische Element 2 zentral ohne seitliche Versätze erfolgt, so daß die piezoelektrischen Schichten 3 nicht durch Scherkräfte beschädigt werden können.

Fig. 2 zeigt in einer stark schematisierten Schnittdarstellung ein zweites Ausführungsbeispiel eines erfindungsgemäß ausgestalteten Aktors 1.

In diesem Ausführungsbeispiel ist lediglich ein Zwischenstück 8 zwischen dem Deckel 7 und der Deckplatte 4 vorhanden, während die Bodenplatte 5 direkt auf dem Deckel 7 anliegt. Diese Ausführungsvariante ist besonders einfach herstellbar und daher kostengünstig, birgt jedoch den Nachteil einer weniger großen Wegauflösung als die in Fig. 1 dargestellte Ausführungsvariante mit zwei Zwischenstücken 8.

Fig. 3 zeigt in einer stark schematisierten Schnittdarstellung ein drittes Ausführungsbeispiel eines erfindungsgemäß ausgestalteten Aktors 1.

In diesem Ausführungsbeispiel sind die Zwischenstücke 8 in Form von Kugeln 11 ausgebildet, welche in Ausnehmungen 12 der Deck- und Bodenplatte 4 und 5 sowie der Deckel 7 liegen. Die zentrierende Wirkung der Kugeln 11 ist dementsprechend sehr hoch und damit eine zuverlässige zentrale Krafteinleitung gewährleistet. Zudem sind die Kugeln 11 einfach und kostengünstig herstellbar.

Allerdings ist in diesem Ausführungsbeispiel die Wegauflösung und damit die Einstellbarkeit der Federkonstanten des Gesamtbauteils sehr eingeschränkt.

Die Erfindung ist nicht auf die dargestellten Ausführungsbeispiele beschränkt und insbesondere bei einer Vielzahl von Bauweisen von Brennstoffeinspritzventilen anwendbar. Weiterhin können die Zwischenstücke 8 in beliebiger, den Anforderungen angemessener Weise ausgeführt und beispielsweise in Form von Tellerfedern, Bügelfedern, Kalottenschalen wie in den beschriebenen Ausführungsbeispielen, Rohrdruckfedern etc. ausgebildet sein.

### Bezugszeichenliste

- 1: Aktor
- 2: piezoelektrisches oder magnetostriktives Element
- 3: piezoelektrische oder magnetostriktive Schichten
- 4: Deckplatte
- 5: Bodenplatte
- 6: Gehäuse
- 7: Deckel
- 8: Zwischenstücke
- 9: Auflagekante
- 10: Auflagefläche
- 11: Kugeln
- 12: Ausnehmungen

## Patentansprüche

1. Aktor (1), insbesondere zur Betätigung von Brennstoffeinspritzventilen für Brennstoffeinspritzanlagen von Brennkraftmaschinen, mit einem piezoelektrischen oder magnetostriktiven Element (2), wobei das piezoelektrische oder magnetostriktive Element (2) in einem elastischen Gehäuse (6) gekapselt ist,
**dadurch gekennzeichnet,**
**daß** das piezoelektrische oder magnetostriktive Element (2) mittels zumindest einem Zwischenstück (8) in dem elastischen Gehäuse (6) verspannt ist.

2. Aktor nach Anspruch 1,
**dadurch gekennzeichnet,**
**daß** das piezoelektrische oder magnetostriktive Element (2) aus mehreren gestapelt angeordneten Schichten (3) besteht.

3. Aktor nach Anspruch 1 oder 2,
**dadurch gekennzeichnet,**
**daß** das piezoelektrische oder magnetostriktive Element (2) durch eine Deckplatte (4) und eine Bodenplatte (5) endseitig abgeschlossen ist.

4. Aktor nach Anspruch 3,
**dadurch gekennzeichnet,**
**daß** das zumindest eine Zwischenstück (8) zwischen der Deckplatte (4) und/oder der Bodenplatte (5) und das Gehäuse (6) stirnseitig abschließenden Deckeln (7) angeordnet ist.

5. Aktor nach einem der Ansprüche 1 bis 4,
**dadurch gekennzeichnet,**
**daß** zwei Zwischenstücke (8) vorgesehen sind.

6. Aktor nach Anspruch 4,
**dadurch gekennzeichnet,**
**daß** die Zwischenstücke (8) schalenförmig ausgebildet sind.

7. Aktor nach Anspruch 6,
**dadurch gekennzeichnet,**
**daß** eine kalottenförmig gewölbte Seite der Zwischenstücke (8) an der Deckplatte (4) und der Bodenplatte (5) anliegt.

8. Aktor nach Anspruch 7,
**dadurch gekennzeichnet,**
**daß** die Zwischenstücke (8) mit einer Auflagekante (9) oder einer Auflagefläche (10) an den Deckeln (7) anliegen.

9. Aktor nach Anspruch 6,
**dadurch gekennzeichnet,**
**daß** eine kalottenförmig gewölbte Seite der Zwischenstücke (8) an den Deckeln (7) anliegt.

10. Aktor nach Anspruch 4,
**dadurch gekennzeichnet,**
**daß** die Zwischenstücke (8) in Form von Kugeln (11) ausgebildet sind.

11. Aktor nach Anspruch 10,
**dadurch gekennzeichnet,**
**daß** die Kugeln (11) in in den Deckeln (7), der Deckplatte (4) und der Bodenplatte (5) ausgebildeten Ausnehmungen (12) angeordnet sind.
